# EUROPEAN PATENT SPECIFICATION

(11) **EP 2 495 105 B1**
(45) Date of publication and mention of the grant of the patent: **21.03.2018**
(21) Application number: 09852163.6
(22) Date of filing: 17.12.2009
(51) Int. Cl.: B41M 1/14, H04N 1/54

(54) **MULTI-PRIMARY COLORS PRINTING QUALITY CONTROL METHOD**
VERFAHREN ZUR STEUERUNG DER DRUCKQUALITÄT BEIM DRUCK MIT MEHREREN PRIMÄRFARBEN
PROCÉDÉ DE CONTRÔLE DE LA QUALITÉ D'IMPRESSION DES MULTIPLES COULEURS PRIMAIRES

(43) Date of publication of application: 05.09.2012
(73) Proprietor: Wing King Tong Printing Limited, Hong Kong (CN)
(72) Inventor: YAN, Tak Kin Andrew, Hong Kong (CN)
(74) Representative: Peters, Hajo
(86) International application number: PCT/CN2009/001490
(87) International publication number: WO 2011/072425

(56) References cited:
- EP-A2- 0 685 962
- EP-A2- 0 833 500
- EP-A2- 0 869 663
- WO-A1-2009/143647
- JP-A- 2001 322 225
- JP-A- 2005 313 347
- JP-A- 2008 255 129
- US-A- 4 310 248
- US-A1- 2005 150 411
- US-A1- 2006 102 488
- STEPHEN HERRON: "An Exploration of the Pantone Hexachrome Six-Color System Reproduced by Stochastic Screens", PROCEEDINGS OF THE COLOR IMAGING CONFERENCE: COLOR SCIENCE,SYSTEMS AND APPLICATIONS, XX, XX, 19 November 1996 (1996-11-19), pages 114-120, XP002182237,

## Description

The invention relates to a method for controlling print quality, and more particularly, to a method for controlling multicolor print quality.

Basic color theory is defined and can be found in primary school textbooks. The color wheel is a common tool for explaining color theory. Basically, the full color spectrum is composed of six common colors: magenta (M), red (R), yellow (Y), green (G), cyan (C), and blue (B). Magenta, yellow, and cyan are the primary colors of subtractive color theory, which is used to make, for example, inks and paints. Red, green and blue are the primary colors of the additive transmission rules, used in electronics and light technologies, such as TV projection and scanning optical applications.

The primary color group comprising magenta, yellow, and cyan has been separated based on the subtractive method and filter glass, to which black is added as image booster. This constitutes the basis of the printing industry.

Traditionally, manual color filtering technologies were used to separate colored pictures, using color optical lens filters, into the CMY printing channels. This methodology created significant challenges for skill laborers. For many decades, the printing industry employed CMYK colored printing inks (where "K" indicates a black color) to simulate full color reproduction using a small color space.

Computer technologies have continuously improved the application of the CMYK color channels for printing. The printing industry has adopted fast electronic data calculations, storage space facilities, and digitalized optical color reproduction techniques. Manual color separation is no longer necessary. Multi-zone color separation via data processing and electronic filtering is sufficient as long as the correct color channel values are selected as calculation inputs. Color channels other than CMY may also be used, and digital ink jet color printers can handle as many as 12 color channels to produce a color gamut that is indistinguishable from the real world color gamut detected by the human eye. Many colors may be used for printing, as long as the color ink channels provide digital color separation. Hi-Fi color printing has recently become available. Hi-Fi printing can overcome the difficulties associated with true color production when using CMYK printing, which results in a narrow color gamut. Researchers have discovered that the addition of purer secondary printing ink colors, that is, red, green, and blue, or purer tertiary color groups, that is, cyan + red, yellow + green, magenta + blue, etc., or any of two, three, or more colors between each color group, yield color representations that are more accurate than those created by the primary CMY colors. The wider resultant color gamut provides a better match for the original color spectrum detected by the human eye. Hi-Fi color printing is an ultimate goal of multicolor reproduction technologies, developed to meet today's expectations for color fidelity.

In ink-based printing methods, the true RGB secondary colors are produced by combining two primary colors, that is, red = yellow + magenta (R = Y + M), green = cyan + yellow (G = C + Y) and blue = magenta + cyan (B = M + C). In the "WKTone neutral grey balance control system," pre-determined primary color halftone values are mixed together to form neutral grey shades, then are compared with monochrome pre-determined halftone black as a reference to aid color balance correction. Conventional secondary and tertiary colors are simulated by applying the natural color gamut data to accurately produce the specific secondary color pigments and tertiary color pigments. This improves some of the traditional printing imperfections from color space simulations, yielding a more accurate color balance. This technique can be used in multicolor printing production techniques.

Formation of simulated secondary, tertiary, and other color groups: CMY is the primary color group used in the print production of multicolor pictures. When any two of these three primary colors are combined, they form the secondary colors RGB. Further combinations of a primary color with a secondary color thereof will form a tertiary color. By further combining the color groups, a full-color picture can be simulated. Because the secondary, tertiary, quaternary colors, and so on are composed of the primary source colors CMY artificial pigments or dyes, color mixing results are limited in the accuracy with which the colors may be reproduced. Therefore, the printing industry has suffered from inaccurate color reproduction for decades.

What is "Hi-Fi" printing? Hi-Fi printing is a printing method in which additional ink colors are used to extend the color gamut coverage, providing optimal color images and achieving optimal reproductions that simulate natural color schemes. The combinations most commonly used in industry are the hexachrome color printing combinations, with six colored inks (CMYK + orange + green), or the heptachrome color printing combinations, with seven colored inks (CMYK + RGB).

Why does the industry require Hi-Fi color printing? Conventional CMYK color printing production process have suffered from an insufficient color gamut due to limits in the availability of mixed colors using the CMY primary colors, which form a narrow color gamut. Hi-Fi color printing can overcome the obstacles of true color production, as it can enrich the color space and better simulate the original color scheme.

Although multicolor production technologies are available, the industry does not have sufficient color management methods to easily determine and control the ink usage balance during high-speed printing processes. It is difficult for machine operators to visualize all color channels to control imbalanced inking conditions and respond quickly and accurately. Conventional CMYK electronic reading devices cannot effectively interpret the secondary and subsequent (non-primary) color values for accurate measurement.

Because the printing industry has lacked an accurate and effective multicolor quality control technique, this invention provides a multicolor print quality control method.

Based on the neutral grey balance theory, neutral grey balance is the overprinting result of a pre-determined percentage (%) of each color group component, e.g., three primary colors: cyan, magenta, and yellow; or the secondary colors: red, green, and blue with its opposite primary color; or the tertiary colors: cyan & green, cyan & blue, magenta & blue, magenta & red, yellow & red, and yellow & green, which each comprise the sum of two opposite primary colors.

When any color changes its value, the neutral grey shade will also change its value and shift the grey shade accordingly, either towards the overdosed color, if in excess or towards the opposing color, if deficient.

The Munsell color balance theory describes the grey balance using the principle of the natural color spectrum in which the RGB colors (red, green, and blue) each has an accurate and distinct color value. Each secondary color contains two primary color elements. By adding the relevant opposite primary color, each RGB color can be neutralized to a neutral grey shade to form the WKTone neutral grey tones (NGTs). The NGTs are produced by the combinations red + cyan, green + magenta, and blue + yellow. If any of the NGT component colors (CMYRGB) changes its value, the neutral grey tone will shift its shade accordingly, either towards the excessive color when in excess or towards the opposite color when deficient. Therefore, by using the WKTone design, each visual NGT target is filled with pre-determined CMYRGB % halftone dots as a neutral grey balance quality control target in the appropriate area. The pre-determined "K" % halftone (MGT) patches are placed as a reference guide, and the MGT and NGT are used to visually match the reference targets. These targets guide ink adjustments to achieve accurate multicolor neutral grey balance conditions. This technique is used in seven-color printing.

Color neutral grey balance control in hexachrome printing may be achieved by applying the same principle as is used for seven-color method. For example, an orange color is composed of two parts yellow and one part magenta (2Y+1M), to form a tertiary color. To create a balanced neutral grey tone for this condition using the Munsell color balance theory, neutralization is performed by adding the appropriate opposite color(s), such as one part magenta and two parts cyan (1M+2C) to the orange. The neutralization result is (2Y+1M)+(1M+2C)=(2Y+2M+2C)=2(Y+M+C). Simplifying this result yields the NGT (C+M+Y), equivalent to the WKTone print quality control neutral grey balance working principle. The formation of other NGT colors follows the same principle.

The invention provided is a method for controlling multicolor print quality according to claim 1.

The secondary colors are red (R), green (G), blue (B). The opposite primary colors are defined as follows: the opposite color to the secondary color R is C, the opposite color to the secondary color G is M, the opposite color to the secondary color B is Y. The appropriate halftone % secondary color is added to the opposite primary color to yield the NGT.

The tertiary color is formed by combining a pre-determined % of the primary and secondary color, for example, cyan & green (C + G), cyan & blue (C + B), magenta & blue (M + B), magenta & red (M + R), yellow & red (Y + R), and yellow & green (Y & G). The appropriate halftone % tertiary colors are added to the opposite primary color to yield the NGT For example, cyan & green's opposite primary colors are yellow & magenta, cyan & blue's opposite primary colors are magenta & yellow, magenta & blue's opposite primary colors are cyan & yellow, magenta & red's opposite primary colors are yellow & cyan, yellow & red's opposite primary colors are magenta & cyan, and yellow & green's opposite primary colors are cyan & magenta.

The quaternary, fifth, and other color groups formed from primary colors. The appropriate halftone % quaternary or fifth colors are added to the opposite primary color(s) to yield the NGT

The secondary color quantity of the color black "K" halftone (MGT) and a printing job is preset by applying the opposite color method to yield MGT and NGT dual grey patches which are accurately overprinted and placed together to cover up the printing surface, thereby providing an operator with a consistent visual reference aid for grey tone analysis to determine the degree of matching and adjust color change values appropriately.

Both grey patches (MGT) and NGT patches is designed as part of the printing images and integrated into the job by placement at appropriate positions, thereby providing a tool for visually assessing color accuracy, by visual inspection or automated analysis.

A neutral grey sample is designed according to NGT and the color black "K" halftone (MGT) for matching purposes at the proof stage, thereby providing a printing job with a visual and machine-readable color reference guide.

An automatic scanner is applied to collect grey patch color values using optical technologies, and an electro-spectro scanner is used in closed loop operation to continuously read and an automatic computing software analyzes color shift values and automatically adjusts the imbalanced color values, thereby providing an operator with a visual target to confirm whether or not the automatic correction result is acceptable.

An electronic component element and optical technologies is used to design the neutral grey patch reference guide and integrate the guide into the monitor's RGB secondary color light source to calibrate the color by creating neutral grey conditions, thereby providing a visual reference guide and reading device comparison usage values.

According to the job requirements, an appropriate color pattern is designed in a particular shape using halftone patches to form a sample reference guide; the color patch patterns is accurately printed in register, placed adjacent to each other and across the width of the printing surface.

An automatic color scanning device is used to repeatedly collect color values for color correction analysis computations to determine color shifting values, thereby providing a visual reading aid to the operator to assist in analyzing the automatic color correction results.

According to NGT, MGT patches, and halftone patches designed according to the required colors and patterns, a single color progressive proof is designed as a proofing reference guide, in the form of a selected portion of a color proof, or as a proof with a full color overprint, depending on the production work flow requirement, thereby providing a job reference guide for use with visual comparison.

The grey balance principle is defined under the optical theory as a pre-determined % color value in which equal portions of primary colors are overprinted on each other to form a black color, and at the 50% condition, a grey shade is formed. Because different ink manufacturers cannot provide the same primary color shade, color shades cannot be unified. Therefore, the selection of different ink manufacturer printing ink sets requires determining the primary color % necessary to form the NGTs. This method provides black color patches MGT to assist with visual comparison.

Particular color reference patches are selected and replaced with selected primary and secondary colors to yield 100% single color solid and pre-determined particular single color halftones, thereby providing an operator with dot gain value information.

WKTone (Hi-Fi) comprises a variety of features. The number of colors selected for production permits NGTs to be produced using combinations other than the three primary colors for comparing with black MGT This visual reference system can be used in many printing applications. Printed results can be visually assessed quickly, and real-time corrections may be made effectively to reduce the number of quality control steps taken in a printing run.

Each time an automatic reading device finishes collecting the color shift information and the color correction data, the WKTone (Hi-Fi) provides a visual target to assist an operator in verifying whether correction steps are required, thereby creating a "silent" and "effective" system between the operator and the machine. If the reading device mistakenly collects the wrong correction data, causing WKTone (Hi-Fi) NGT or MGT color shifting, the system will positively translate both grey tones into a non-matching condition. The operator can (in real time) visually understand grey imbalance situations without the need for a magnifying glass or a reading device. Defective results can thereby be accurately determined.

The WKTone (Hi-Fi) multicolor method can provide single colors, partial colors, and all required color production usages, simply by computing the color groups of NGTs. Opposite primary, secondary, tertiary, etc., colors may be used to produce a neutral grey tone, which can assist the visual quality assessment process by comparison with the "K" MGT for color correction purposes.

Because RGB secondary colors are used in color monitors, appropriate electronic or optical filters may be added to produce a neutral grey shade, which can be compared with a reference grey patch.

Advantages of the invention are summarized below:
1. Linear graphic devices containing neutral grey tone information for visual assessment of printing consistency. This can simplify the color differentiation checking period and speed up the color adjustment process.
2. Continuous monitoring of printing press running status for imperfections, doubling, gear marking, mechanical wearing, scumming, inconsistency of ink supply, automatic color bar scanning device malfunctions, and other printing-related problems.
3. Color references are positioned side by side, creating a diffusion referencing function. No visual memory is required for tone matching, assisting with the process of instant color adjustment. The operator can quickly and accurately compare and adjusts for color matching in real time.
4. Quality control methods can be widely used between the proof-making and bulk production steps.
5. Quality control methods can be widely used in many printing processes. It is especially beneficial when applied to lithographic printing, digital printing, digital and conventional proofing, and electromagnetic digital printing. The method can assist in mechanical or digital electro-printing, digital electromagnetic production, and can assist in the calibration of monitors (e.g. LED screen)
6. Certain jobs may require different grey balance NGT values as target references. This method overcomes grey bar restrictions in standard gray balance values as long as the whole job is conducted under matching conditions.
7. Certain jobs may require pre-defined color values as a target reference. This method may be applied as long as the whole job is conducted under matching conditions.
8. Unique pre-determined neutral grey pattern designs can be integrated into the print job content.
9. The visual assessment method is facilitated by introducing a multicolor neutral grey balance quality control system that can effectively highlight the neutral grey tone to deal with inking imbalance conditions.
10. The simple method design provides an operator with an instant overview of the ink balance, thereby facilitating ink adjustment and avoiding information overload and visual confusion.
11. The print quality control method can provide a uniform color patch environment over 100% coverage of the job width for color density reading equipment manufacturers to precisely collect grey tone shade value changes via photoelectronic reading devices. This system can be used in automatic scanning and correction devices that rapidly and accurately collect data and density values so that an operator can react quickly to handle any required corrections.
12. By selecting halftone color patches as a reference guide for printing, rather than using 100% solid color patches for quality control assistance, the color imbalance overprint analysis can be simplified and the reading time can be reduced.
13. A deficient color element can be easily identified without using expensive and sophisticated ink density reading equipment.
14. This system is a universal tool and can be used in a variety of color management control systems as a quick reference device.
15. NGT shade changes reveal the presence of imbalances in the chosen ink value(s).
16. Neutral grey tone shade changes appear quickly between printed sheets and can indicate printing machine mechanical defects or printing material instability conditions.
17. Inking adjustments are usually based on CMY overprinting results. Conventional methods use only individual color standard density readings not made in the overprinting condition to reflect the actual overprinted condition. However, imbalanced inking conditions can occur without such indications.
18. This system provides a visual target for the operator and a reading aid for a reading device that helps the operator confirm whether or not the automatic correction result is acceptable. This method is a "silent" and "effective" communication method.
19. This method permits the design of appropriate color shapes in the form of halftone patches (according to the job requirements), as a reference guide for the selection of printing colors. These target color patches can be used for bulk production usage.
20. This method provides a means for visually monitoring color adjustments. Appropriate electronic or optical technologies may be used to adjust RGB secondary colors to form grey shades for matching with a black neutral grey tone by comparison. This method facilitates the visual monitoring of RGB color balance calibration steps.
21. This system creates color patches as proofing reference guides using the color group. The guides may be formed using different groupings of single color progressive proofs or using a portion of a selected number of color proofs and the proof with a full color overprint, depending on the production sequencing work flow requirements. This method provides a job reference guide for visual assessment of consistency and color reading device analysis.
22. The print quality control method may be implemented in software form, available as a digital download and providing an output in an analog form, such as film wedges.
23. The system can provide accurate individual ink zone/ink key control during the printing production process. The pre-determined neutral grey patches are placed to maximize their coverage, providing inking value information covering the full printing width and avoiding incomplete inking value information.
24. No restrictions on ink set usages. Any ink set can be used to provide the neutral grey tone(s) as long as the balancing conditions are controlled.
25. The control system can be as small as possible as long as it is readable. The height and width are not restricted.
26. No restrictions on the lines per inch screening resolution.
27. The system can use any halftone screening style, for example, AM/FM.
28. Screen angles may be normal, and no particular screen angle setting is required for each color.
29. The unique "pre-determined" system has no restrictions on shape and size of the neutral grey tone. Midtone and solid areas may be placed over the "K" grey patch as long as the comparison is readable and measurable using equipment when necessary.
30. Controlling methods can provide accurate, tight, registered printing environments using MGT and NGT patches to enable visual comparison. Both grey tones can be used to indicate the presence of misalignment in the MGT and NGT patches for reference purposes. A white line formed between the MGT and NGT can indicate the spacing between MGT and NGT patches. A dark line between the MGT and NGT patches can indicate overlap in the MGT and NGT patches. These features can provide misalignment information.

The invention WKTone (HiFi), combining with primary colour and WKTone Neutral Grey Balance theory, design a neutral grey balance colour control system, in the method for stripping in the print job electronically or in a form of film, in which:
FIG. 1 to FIG. 10 show the primary colors plus secondary colors with reference to the accompanying drawings:
   FIG. 1 is a plan view of the monochrome production version;
   FIG. 2 is a plan view of the color production version;
   FIG. 3 is a plan view of the cyan, magenta, yellow, red, green, blue and black overprint design;
   FIG. 4 is a plan view of the cyan design (C);
   FIG. 5 is a plan view of the magenta design (M);
   FIG. 6 is a plan view of the yellow design (Y);
   FIG. 7 is a plan view of the red design (R);
   FIG. 8 is a plan view of the green design (G);
   FIG. 9 is a plan view of the blue design (B);
   FIG. 10 is a plan view of the black design (K);
FIG. 11 to FIG. 20 is the primary color plus tertiary color with reference to the accompanying drawings:

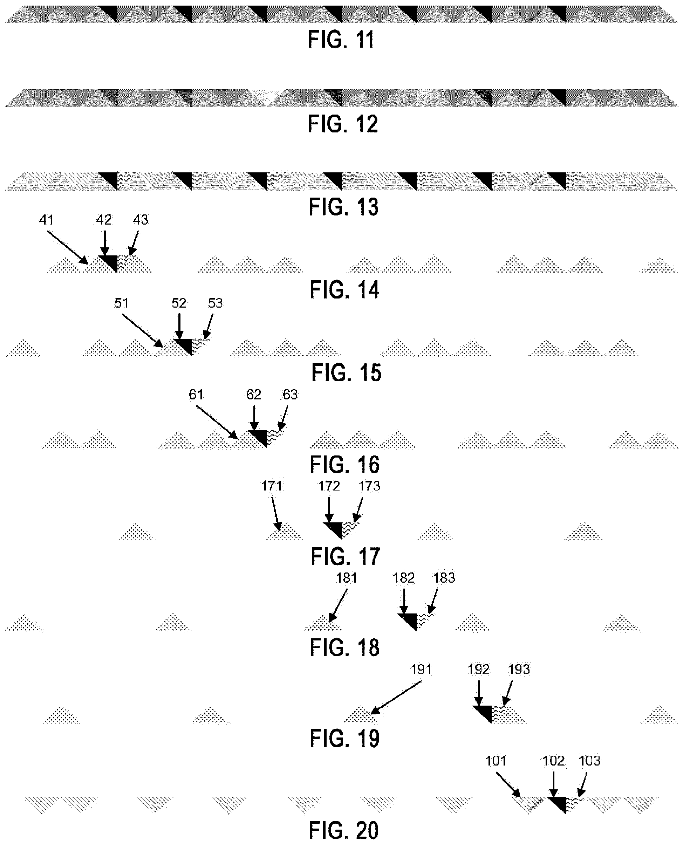

   FIG. 11 is a plan view of the monochrome production version;
   FIG. 12 is a plan view of the color production version;
   FIG. 13 is a plan view of the cyan, magenta, yellow, yellow + red, cyan + green, magenta + blue and black overprint design;
   FIG. 14 is a plan view of the cyan design (C);
   FIG. 15 is a plan view of the magenta design (M);
   FIG. 16 is a plan view of the yellow design (Y);
   FIG. 17 is a plan view of the yellow + red design (R);
   FIG. 18 is a plan view of the cyan + green design (G);
   FIG. 19 is a plan view of the magenta + blue design (B);
   FIG. 20 is a plan view of the black design (K);

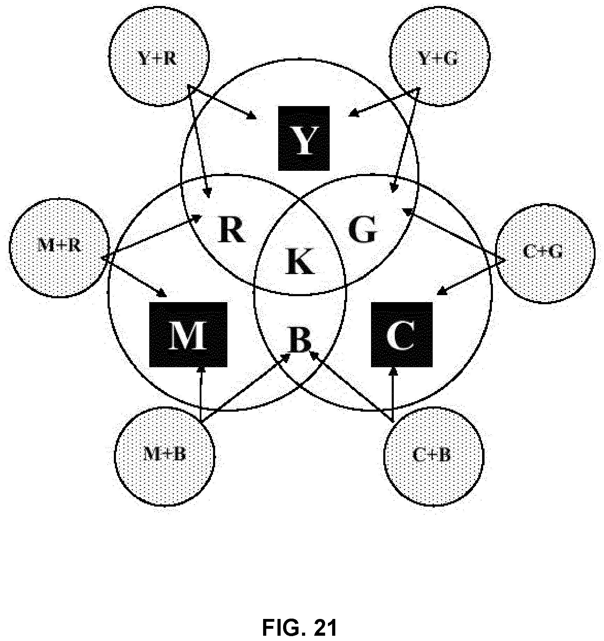

FIG. 21 is the primary color and subsequent color theory drawing:
   Primary color: cyan, magenta, yellow
   Secondary color: red, green, blue
   Tertiary color: cyan + green, cyan + blue, magenta + blue, magenta + red, yellow + red, yellow + green.

A detailed description of this invention is given below to provide further details regarding the description of the invention. Based on the WKTone theory, this invention designed CMYKRGB halftone percentage dots in appropriately shaped patches placed in a series, inverted with respect to each other, and tightly overprinted in register, to provide a grey environment for visual consistency assessment and quality control reference purposes. The "K" grey tone reference guide is a primary quality control aid and is used to form a "C, M, Y, CR, MG, YB" overprinted neutral grey tone reference target. This reference target has no length restrictions; it can cover the full job width without interruptions in the color information to facilitate color balance correction processes. Patches containing 100% CMYRGBK single solid colors and pre-determined halftone patches in a certain % may be used to replace regions of the "K" grey patches to provide the operator with additional dot gain information.

WKTone (Hi-Fi) features a unique color balance control function, does not carry excessive data, is based on requirements for determining appropriate patterns and patch shapes, and dynamically provides the user with a working environment for color quality assessment. This method accommodates multicolor elements by establishing different combinations of arrangements that are tightly registered and overprinted to build the WKTone (Hi-Fi) color quality control system.

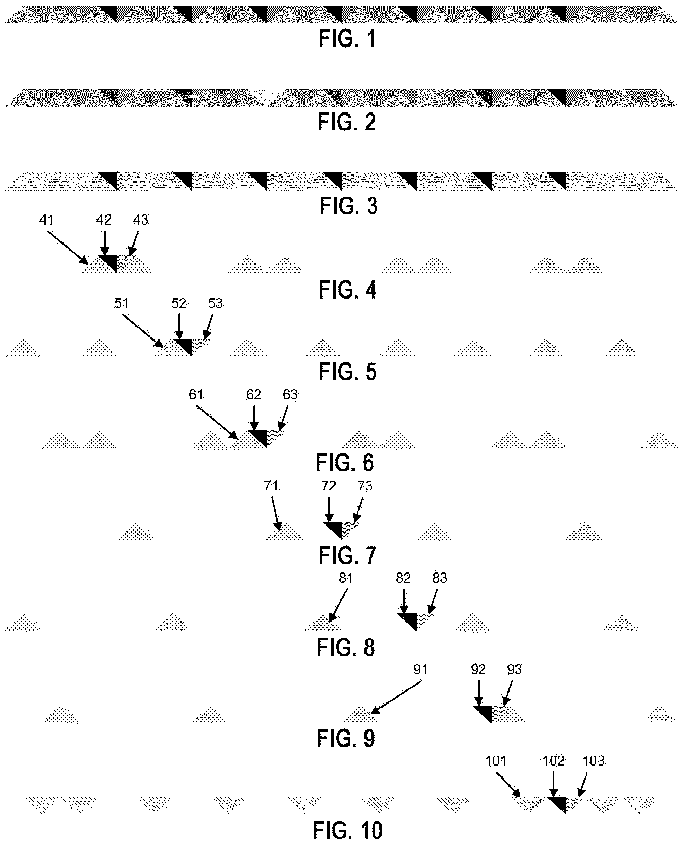

FIG. 1 is a secondary color WKTone (Hi-Fi) multicolor quality control system monochrome production version. FIG. 2 is the CMYRGBK color accurate overprinting result. FIG. 3 is a mechanical technical drawing. FIG. 4 is the plan view of the cyan color, FIG. 5 is the plan view of the magenta color, FIG. 6 is the plan view of the yellow color, FIG. 7 is the plan view of the red color, FIG. 8 is the plan view of the green color, FIG. 9 is the plan view of the blue color, and FIG. 10 is the plan view of the black color, which can be used to describe the individual color technical drawings. Each color had been designed with pre-determined halftone patterns 41, 51, 61, 71, 81, 91, and 101 for NGT neutral grey patch overprinting usages, 100% solid spot color patches 42, 52, 62, 72, 82, 92, and 102, as well as pre-determined halftone color patches 43, 53, 63, 73, 83, 93, and 103. These patches can be used to continuously monitor the single color solid density and the dot gain information. To obtain the best color balance in a printing result, the "K" grey tone and the neutral grey tone shall be in matching conditions, similar in tone shade, and not influenced by excessive "C," "M," "Y," "R," "G," "B" mixed color tones, thereby maintaining optimal grey balance conditions.

FIG. 11 is the tertiary color WKTone (Hi-Fi) multicolor quality control system monochrome production version. FIG. 12 is the CMYYrCgMbK color accurate overprinting result. FIG. 13 is a mechanical technical drawing. FIG. 14 is the plan view of the cyan color, FIG. 15 is the plan view of the magenta color, FIG. 16 is the plan view of the yellow color, FIG. 17 is the plan view of the yellow + red color, FIG. 18 is the plan view of the cyan + green color, FIG. 19 is the plan view of the magenta + blue color, and FIG. 20 is the plan view of the black color, such that each figure shows an individual color technical drawing. Each color had been designed with pre-determined halftone patterns 41, 51, 61, 171, 181, 191, and 101 for the NGT neutral grey patch overprinting uses. 100% solid spot color patches 42, 52, 62, 172, 182, 192, and 102 as well as pre-determined halftone color patches 43, 53, 63, 173, 183, 193, and 103 this provide continuous single color solid density and dot gain information. To obtain optimal color balance printing results, the "K" grey tone and the neutral grey tone are in matching conditions, similar in tone shade, and are not influenced by excessive "C," "M," "Y," "Yr," "Cg," "Mb" mixed color tones, thereby maintaining optimal grey balance conditions.

Specifically, FIG. 3 to FIG. 10 and FIG. 14 to FIG. 20 are the designs for the printed image of each color, such that each patch is adjacent to the next. FIG. 7, FIG. 8, and FIG. 9 are for the secondary colors, and FIG. 17, FIG. 18, FIG. 19 are for the tertiary colors. By combining the pre-determined halftone primary colors FIG. 4, FIG. 5, FIG. 6, FIG. 14, FIG. 15, FIG. 16 with the subsequent color groups, a NGT is formed. Secondary color NGT composition versions are: FIG. 4 + FIG. 7 (cyan + red), FIG. 5 + FIG. 8 (magenta + green), and FIG. 6 + FIG. 9 (yellow + blue). Tertiary color NGT composition versions are: FIG. 14 + FIG. 15 + FIG. 17 (cyan + magenta + yellow red), FIG. 15 + FIG. 16 + FIG. 18 (magenta + yellow + cyan green), and FIG. 14 + FIG. 16 + FIG. 19 (cyan + yellow + magenta blue). Within each color patch, the black "K" monochrome grey tones (MGT) in FIG. 10 and FIG. 20 are used as a single grey tone reference guide for the primary and color groups' NGT target uses. FIG. 2 and FIG. 12 show the overprinting results of the above color groups, which can be used for visual assessment or with reading devices that retrieve data for comparison and to aid in color correction color shifting control. The overprinting results provide a visual reference for the operator to verify the accuracy of the automatic reading device color correction process. FIG. 21 shows the color wheel of the primary and subsequent color group combination theory.

## Claims

1. A method for controlling multicolor print quality using inks of primary colors and composite colors, the primary color inks being cyan (C), magenta (M), and yellow (Y), and the composite color inks being formed by mixing inks of the primary colors; the method comprising
a) forming halftone color patches of the primary colors, the composite colors, and a black color "K" using a computer, and placing the halftone color patches of the primary colors, the composite colors and the black color "K" onto a print substrate; wherein the forming includes:
overprinting a halftone color patch of a composite color ink with a halftone color patch of an opposite primary color ink thereof in a pre-determined halftone percentage to yield neutral grey tone (NGT);
b) visually comparing the neutral grey tone (NGT) formed in a) with the black color "K" halftone (MGT) formed in a) which serves as a monochrome gray reference in the color patches; and
c) based on the visual comparison in b), assessing ink balance in the inks of the primary colors and the composite colors.

2. The method of claim 1, **characterized in that** the composite colors are red (R), green (G), blue (B); the opposite color to the composite color R is C, the opposite color to the composite color G is M, the opposite color to the composite color B is Y; and the appropriate halftone percentage composite color is added to the opposite primary color to yield the neutral grey tone (NGT).

3. The method of claim 1, **characterized in that** the composite color quantity of the color black "K" halftone (MGT) and a printing job is preset by applying the opposite color method to yield MGT and NGT dual grey patches which are accurately overprinted and placed together to cover up the printing surface, thereby providing an operator with a consistent visual reference aid for grey tone analysis to determine the degree of matching and adjust color change values appropriately.

4. The method of claim 1, **characterized in that** both grey patches and NGT patches is designed as part of the printing images and integrated into the job by placement at appropriate positions, thereby providing a tool for visually assessing color accuracy, by visual inspection or automated analysis.

5. The method of claim 1, **characterized in that** a neutral grey sample is designed according to NGT and the color black "K" halftone (MGT) for matching purposes at the proof stage, thereby providing a printing job with a visual and machine-readable color reference guide.

6. The method of claim 1, **characterized in that** an automatic scanner is applied to collect grey patch color values using optical technologies, and an electro-spectro scanner is used in closed loop operation to continuously read and an automatic computing software analyzes color shift values and automatically adjusts the imbalanced color values, thereby providing an operator with a visual target to confirm whether or not the automatic correction result is acceptable.

7. The method of claim 1, **characterized in that** an electronic component element and optical technologies is used to design the neutral grey patch reference guide and integrate the guide into the monitor's RGB composite color light source to calibrate the color by creating neutral grey conditions, thereby providing a visual reference guide and reading device comparison usage values.

8. The method of claim 1, **characterized in that** according to the job requirements, an appropriate color pattern is designed in a particular shape using halftone patches to form a sample reference guide; the color patch patterns is accurately printed in register, placed adjacent to each other and across the width of the printing surface.

9. The method of claim 8, **characterized in that** an automatic color scanning device is used to repeatedly collect color values for color correction analysis computations to determine color shifting values, thereby providing a visual reading aid to the operator to assist in analyzing the automatic color correction results.

10. The method of claim 1 or 8, **characterized in that** according to NGT, MGT patches, and halftone patches designed according to the required colors and patterns, a single color progressive proof is designed as a proofing reference guide, in the form of a selected portion of a color proof, or as a proof with a full color overprint, depending on the production work flow requirement, thereby providing a job reference guide for use with visual comparison.

11. The method of claim 1 or 8, **characterized in that** particular color reference patches are selected and replaced with selected primary and composite colors to yield 100% single color solid and pre-determined particular single color halftones, thereby providing an operator with dot gain value information.

## Patentansprüche

1. Verfahren zur Steuerung der Druckqualität beim Druck mit mehreren Farben unter Anwendung von Druckfarben von Primärfarben und Mischfarben, wobei die Primärdruckfarben Cyan (C), Magenta (M) und Gelb (Y) sind, und die Mischdruckfarben durch Mischen von Druckfarben der Primärfarben gebildet werden; welches Verfahren Folgendes umfasst
a) Bilden von Halbtonfarbfeldern der Primärfarben, der Mischfarben und einer schwarzen Farbe "K" unter Anwendung eines Computers und Anbringen der Halbtonfarbfelder der Primärfarben, der Mischfarben und der schwarzen Farbe "K" auf einen Druckträger; wobei das Bilden Folgendes umfasst:
Überdrucken eines Halbtonfarbfelds einer Mischdruckfarbe mit einem Halbtonfarbfeld einer entgegengesetzten Primärdruckfarbe davon in einem vorgegebenen Halbtonprozentanteil, um den neutralen Grauton (NGT) zu erreichen;
b) visuelles Vergleichen des in a) gebildeten neutralen Grautons (NGT) mit dem in a) gebildeten Halbton der schwarzen Farbe "K" (MGT), dienend als eine monochrome Graureferenz in den Farbfeldern; und
c) basierend auf dem visuellen Vergleich in b), Bewerten der Druckfarbenbalance in den Druckfarben der Primärfarben und der Mischfarben.

2. Verfahren nach Anspruch 1, **dadurch gekennzeichnet, dass** die Mischfarben Rot (R), Grün (G), Blau (B) sind; die entgegengesetzte Farbe von der Mischfarbe R C ist, die entgegengesetzte Farbe von der Mischfarbe G M ist, die entgegengesetzte Farbe von der Mischfarbe B Y ist; und der passende Halbtonprozentanteil von Mischfarbe zur entgegengesetzten Primärfarbe zugesetzt wird, um den neutralen Grauton (NGT) zu erreichen.

3. Verfahren nach Anspruch 1, **dadurch gekennzeichnet, dass** die Mischfarbenmenge des Halbtons der schwarzen Farbe "K" (MGT) und ein Druckauftrag durch Anwenden des Verfahrens der entgegengesetzten Farben voreingestellt werden, um MGT- und NGT-Doppelgraufelder zu erreichen, die genau überdruckt und zusammen angeordnet werden, um die Druckoberfläche abzudecken, wodurch dem Bediener ein konsistentes visuelles Referenzhilfsmittel zur Grautonanalyse bereitgestellt wird, um den Übereinstimmungsgrad zu bestimmen und die Farbänderungswerte passend einzustellen.

4. Verfahren nach Anspruch 1, **dadurch gekennzeichnet, dass** sowohl Graufelder als auch NGT-Felder als Teil der Druckbilder ausgebildet werden und in den Auftrag durch Anbringung in passenden Positionen integriert werden, wodurch ein Werkzeug zur visuellen Bewertung der Farbgenauigkeit durch visuelle Inspektion oder automatisierte Analyse bereitgestellt wird.

5. Verfahren nach Anspruch 1, **dadurch gekennzeichnet, dass** eine Neutralgrauprobe gemäß NGT und dem Halbton der schwarzen Farbe "K" (MGT) zu Übereinstimmungszwecken in der Prüfdruckstufe ausgebildet wird, wodurch ein Druckauftrag mit visueller und maschinenlesbarer Farbreferenzanleitung bereitgestellt wird.

6. Verfahren nach Anspruch 1, **dadurch gekennzeichnet, dass** ein automatischer Scanner angewendet wird, um Graufeldfarbwerte unter Anwendung von optischen Technologien einzusammeln, und ein Elektro-Spektro-Scanner in Endlosschleifenbetrieb angewendet wird, um kontinuierlich zu lesen, und eine automatische Computersoftware Farbverschiebungswerte analysiert und die unausgeglichenen Farbwerte automatisch einstellt, wodurch dem Bediener ein visuelles Ziel bereitgestellt wird, um zu bestätigen, ob das automatische Korrekturergebnis akzeptabel ist oder nicht.

7. Verfahren nach Anspruch 1, **dadurch gekennzeichnet, dass** ein elektronisches Komponentenelement und optische Technologien verwendet werden, um die Neutralgraufeld-Referenzanleitung auszubilden und die Anleitung in die RGB-Mischfarbenlichtquelle des Monitors zu integrieren, um die Farbe durch Herstellen von Neutralgraubedingungen zu kalibrieren, wodurch eine visuelle Referenzanleitung und Leseeinrichtungvergleichswerte bereitgestellt werden.

8. Verfahren nach Anspruch 1, **dadurch gekennzeichnet, dass,** gemäß den Auftragsanforderungen, ein passendes Farbmuster in einer bestimmten Form unter Anwendung von Halbtonfeldern ausgebildet wird, um eine Probereferenzanleitung zu bilden; die Farbfeldmuster genau in Register gedruckt werden, neben einander und quer über die Breite der Druckoberfläche angeordnet werden.

9. Verfahren nach Anspruch 8, **dadurch gekennzeichnet, dass** eine automatische Farbscaneinrichtung angewendet wird, um wiederholt Farbwerte für Farbkorrekturanalyseberechnungen einzusammeln, um Farbverschiebungswerte zu bestimmen, wodurch dem Bediener ein visuelles Lesehilfsmittel zur Unterstützung bei der Analyse der automatischen Farbkorrekturergebnisse bereitgestellt wird.

10. Verfahren nach Anspruch 1 oder 8, **dadurch gekennzeichnet, dass,** gemäß NGT-, MGT-Feldern und Halbtonfeldern, die nach den erforderlichen Farben und Mustern ausgebildet sind, ein progressiver Einzelfarbprüfdruck als eine Prüfdruckreferenzanleitung in Form eines ausgewählten Teils eines Farbprüfdrucks oder als ein Prüfdruck mit einem Vollfarbenüberdruck ausgebildet wird, abhängig von der Produktionsablaufanforderung, wodurch eine Auftragsreferenzanleitung zur Verwendung mit visuellem Vergleich bereitgestellt wird.

11. Verfahren nach Anspruch 1 oder 8, **dadurch gekennzeichnet, dass** bestimmte Farbreferenzfelder ausgewählt werden und durch ausgewählte Primär- und Mischfarben ersetzt werden, um 100 % Einzelfarbfeststoff und vorgegebene bestimmte Einzelfarbhalbtöne zu erreichen, wodurch dem Bediener Tonwertzunahmeninformation bereitgestellt wird.

## Revendications

1. Procédé de contrôle de la qualité d'impression multicolore en utilisant des encres de couleurs primaires et de couleurs composites, les encres de couleurs primaires étant cyan (C), magenta (M) et jaune (Y), et les encres de couleurs composites étant formées par le mélange d'encres de couleurs primaires ; le procédé comprenant
a) la formation de patches de couleurs en demi-teintes des couleurs primaires, des couleurs composites, et d'une couleur noire "K" en utilisant un ordinateur, et le positionnement des patches de couleurs en demi-teintes des couleurs primaires, des couleurs composites et de la couleur noire "K" sur un substrat d'impression ; la formation comprenant :
la surimpression d'un patch de couleurs en demi-teintes d'une encre de couleur composite avec un patch de couleurs en demi-teintes d'une encre de couleur primaire opposée dans un pourcentage en demi-teintes prédéterminé pour obtenir la tonalité de gris neutre (NGT) ;
b) la comparaison visuelle de la tonalité de gris neutre (NGT) formée en a) avec la couleur noire "K" demi-teinte (MGT) formée en a) qui sert de référence gris monochrome dans les patches de couleur ; et
c) sur la base de la comparaison visuelle en b), l'estimation de l'équilibre d'encres dans les encres des couleurs primaires et des couleurs composites.

2. Procédé selon la revendication 1, **caractérisé en ce que** les couleurs composites sont le rouge (R), le vert (G), le bleu (B) ; la couleur opposée à la couleur composite R est C, la couleur opposée à la couleur composite G est M, la couleur opposée à la couleur composite B est Y ; et la couleur composite au pourcentage de demi-teinte appropriée est ajoutée à la couleur primaire opposée pour obtenir la tonalité de gris neutre (NGT).

3. Procédé selon la revendication 1, **caractérisé en ce que** la quantité des couleurs composites de la couleur noire "K" demi-teinte (MGT) et un travail d'impression sont prédéfinis en appliquant le procédé de couleur opposée pour obtenir des doubles patches gris de MGT et de NGT qui sont surimprimés et placés ensemble avec précision pour recouvrir la surface d'impression, fournissant ainsi à un opérateur une aide visuelle de référence cohérente pour l'analyse des tons de gris afin de déterminer le degré d'appariement et régler des valeurs de changement de couleur de manière appropriée.

4. Procédé selon la revendication 1, **caractérisé en ce qu'**à la fois, les patches gris et les patches de NGT sont conçus en tant qu'éléments des images d'impression et intégrés dans le travail par le positionnement à des positions appropriées, fournissant ainsi un outil pour évaluer visuellement la précision des couleurs, par l'inspection visuelle ou l'analyse automatisée.

5. Procédé selon la revendication 1, **caractérisé en ce qu'**un échantillon gris neutre est conçu selon NGT et la couleur noire "K" demi-teinte (MGT) pour des fins d'adaptation à l'étape d'épreuve, fournissant ainsi au travail d'impression un guide de référence de couleur visuelle et lisible par machine.

6. Procédé selon la revendication 1, **caractérisé en ce qu'**un scanneur automatique est appliqué pour collecter des valeurs de couleur de patch gris en utilisant des technologies optiques, et un scanneur électro-spectro est utilisé dans une fonction en boucle fermée pour lire en continu et un logiciel de calcul automatique analyse automatiquement des valeurs de changement de couleur et règle automatiquement les valeurs de couleur déséquilibrées, fournissant ainsi à un opérateur une cible visuelle pour confirmer si le résultat de la correction automatique est acceptable ou non.

7. Procédé selon la revendication 1, **caractérisé en ce qu'**un élément de composant électronique et des technologies optiques sont utilisés pour concevoir le guide de référence de patch gris neutre et intégrer le guide dans la source de lumière de couleurs composites RVB du moniteur pour calibrer la couleur en créant des conditions de gris neutre, fournissant ainsi un guide de référence visuel et un dispositif de lecture des valeurs d'utilisation de comparaison.

8. Procédé selon la revendication 1, **caractérisé en ce que**, selon les exigences du travail, un patch de couleur approprié est conçu dans une forme particulière en utilisant des patches en demi-teintes pour former un guide de référence d'échantillon; les motifs de patch de couleur sont imprimés avec précision dans le registre, placés l'un à côté de l'autre et à travers la largeur de la surface d'impression.

9. Procédé selon la revendication 8, **caractérisé en ce qu'**un dispositif de balayage de couleur automatique est utilisé pour recueillir des valeurs de couleur de façon répétée pour des calculs d'analyse de correction de couleur pour déterminer les valeurs de changement de couleur, fournissant ainsi une aide visuelle à l'opérateur pour l'aider dans l'analyse des résultats de correction de couleur automatique.

10. Procédé selon la revendication 1 ou 8, **caractérisé en ce que**, selon NGT, patches MGT et patches de demi-teintes conçus selon les couleurs et motifs requis, une preuve progressive de couleur unique est conçue en tant que guide de référence de preuve, sous la forme d'une portion sélectionnée d'une preuve de couleur, ou en tant qu'épreuve avec une surimpression de couleur pleine, en fonction de l'exigence de flux de travail de production, fournissant ainsi un guide de référence de travail à utiliser avec une comparaison visuelle.

11. Procédé selon la revendication 1 ou 8, **caractérisé en ce que** des patches de référence de couleurs particuliers sont sélectionnés et remplacés par des couleurs primaires et composites sélectionnées pour produire 100% de couleurs uniques solides et des demi-teintes de couleurs particulières prédéterminées, fournissant ainsi à un opérateur des informations de valeur de gain.
